(19) **Europäisches Patentamt**

**European Patent Office**

**Office européen des brevets**

(11) **EP 0 753 671 B1**

(12) **FASCICULE DE BREVET EUROPEEN**

(45) Date de publication et mention
de la délivrance du brevet:
**20.03.2002 Bulletin 2002/12**

(51) Int Cl.⁷: **F15C 5/00**, G01J 5/02

(21) Numéro de dépôt: **96401540.8**

(22) Date de dépôt: **11.07.1996**

(54) **Procédé de fabrication d'éléments de microstructures flottants rigides et dispositif équipé de tels éléments**

Herstellungsverfahren für Elemente von schwimmenden, starren Mikrostrukturen und Vorrichtung, die mit solchen Elementen ausgerüstet ist

Method of manufacturing elements of floating, rigid microstructures and apparatus equipped with such elements

(84) Etats contractants désignés:
**DE GB IT SE**

(30) Priorité: **13.07.1995 FR 9508525**

(43) Date de publication de la demande:
**15.01.1997 Bulletin 1997/03**

(73) Titulaire: **COMMISSARIAT A L'ENERGIE ATOMIQUE**
**75015 Paris Cédex 15 (FR)**

(72) Inventeur: **Vilain, Michel**
**38450 St. Georges de Commiers (FR)**

(74) Mandataire: **Dubois-Chabert, Guy et al**
**BREVATOME**
**3, rue du Docteur Lanceraux**
**75008 Paris (FR)**

(56) Documents cités:
WO-A-94/07115     US-A- 4 116 063
US-A- 4 770 740     US-A- 5 021 663
US-A- 5 367 167

• SENSORS AND ACTUATORS, vol. 20, no. 1/2, 15 Novembre 1989, LAUSANNE, pages 163-169, XP000135240 ESASHI: "Normally Closed Microvalve and Micropump Fabricated on a Silicon Wafer."

## Description

domaine technique

La présente invention se rapporte à un procédé de fabrication d'éléments de microstructure flottants et à un dispositif équipé de tels éléments.

On entend par microstructure flottante une partie d'un dispositif de micromécanique qui est suspendue ou libre par rapport à un substrat.

Par ailleurs, on désigne par élément de microstructure soit l'ensemble de la microstructure soit une partie seulement de la microstructure, telle que, par exemple, des poutres de suspension qui la relient au substrat.

L'invention trouve des applications de façon générale dans le domaine de la fabrication de dispositifs de micromécanique usinés sur des substrats, tels que des micromoteurs, des micromachines, des capteurs, et en particulier des microbolomètres.

Etat de la technique antérieure

Les microstructures sont usuellement réalisées par des techniques de lithographie et de gravure qui permettent de mettre en forme une couche de matériau, ou un empilement de couches qui constitue le corps de la microstructure.

A titre indicatif, et de façon simplifiée, la fabrication des microstructures et plus généralement des dispositifs de micromécanique comprend, dans un premier temps, la réalisation d'un empilement dans lequel la microstructure est usinée. Cet empilement comporte une première couche de support sur laquelle on dépose ou fait croître une couche de matériau sacrificiel, de nature organique ou minérale. On forme ensuite sur la couche sacrificielle une ou plusieurs couches, généralement des couches minces, dans lesquelles est formé le corps de la microstructure.

La forme de la microstructure est définie dans ces couches par des techniques de lithographie et de gravure déjà évoquées. Enfin, l'élimination totale ou partielle du matériau sacrificiel permet la libération totale ou partielle, de la (ou des) microstructure(s) réalisée(s).

Selon le dessin des masques de lithographie utilisés pour la mise en forme des microstructures, les éléments de microstructure peuvent être entièrement libres, tels que par exemple les rotors de micromoteurs, ou supportés de manière plus ou moins rigide par des membranes ou des réservations prévues à cet effet.

Un bon exemple de microstructures concernées par la présente invention est celui des microbolomètres. Un microbolomètre selon l'art antérieur est décrit dans le document US-A-4 116 063. La figure 1 illustre schématiquement les éléments constitutifs essentiels d'un tel microbolomètre. Celui-ci comporte une zone centrale 10 pourvue d'un matériau sensible au rayonnement, apte à générer un signal électrique en réponse à la détection d'un rayonnement. Ce signal varie avec la température de la zone centrale 10, qui est elle-même fonction de l'absorption de l'énergie d'éclairement qu'elle reçoit par l'intermédiaire de moyens optiques non représentés. Une description plus détaillée du fonctionnement et de la structure de la zone centrale sensible 10 d'un bolomètre est donnée par exemple par les documents (1) et (2) référencés à la fin de la présente description.

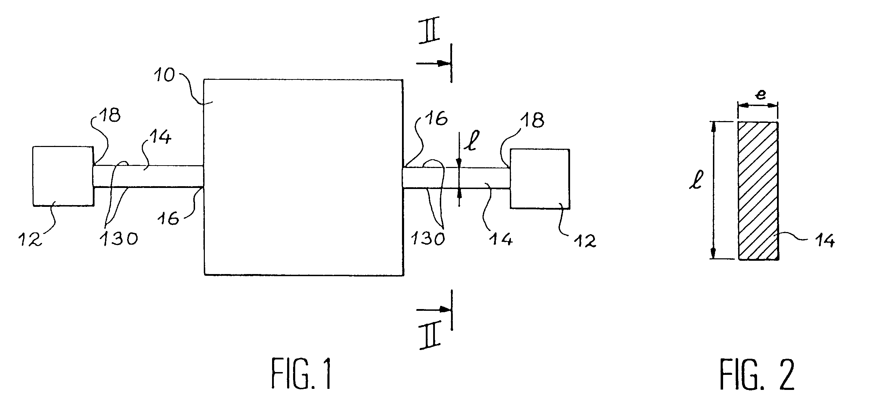

La zone centrale 10 du microbolomètre est reliée à des supports mécaniques rigides 12 par l'intermédiaire de poutres de suspension 14. Les supports mécaniques 12 sont solidaires du substrat de support qui n'est pas représenté sur la figure 1 dans un souci de simplification.

Les poutres de suspension ont habituellement plusieurs fonctions.

Une première fonction mécanique est de maintenir la zone centrale 10 en suspension au-dessus du substrat de support pour éviter tout contact mécanique direct entre ces parties, susceptible de provoquer une perte d'énergie thermique.

Au rôle de maintien mécanique de la zone centrale 10, assuré par les poutres 14 s'ajoute celui du positionnement précis de la zone centrale 10 par rapport au substrat. En particulier, pour améliorer le rendement d'absorption optique de la zone centrale du bolomètre il convient de contrôler l'espacement entre cette zone et la surface du substrat de support sous-jacent.

Une autre fonction des poutres est de constituer des connexions électriques pour transmettre le signal électrique produit par des composants actifs de la zone centrale 10 vers des circuits de lecture et de mesure périphériques, formés par exemple sur le même substrat de support (non représenté).

Une autre fonction ou caractéristique des poutres de suspension est de constituer des isolants thermiques entre la zone centrale 10 et les supports mécaniques 12 solidaires du substrat. En effet, les poutres 14 doivent présenter une résistance thermique maximum entre leurs extrémités 16 et 18 en contact respectivement avec la zone 10 et les supports 12 isothermes avec le substrat.

L'isolement thermique de la zone centrale 10 par rapport aux supports 12 est en effet indispensable pour maximiser son excursion thermique sous l'effet de l'éclairement et éviter que l'énergie thermique ne diffuse vers le substrat qui constitue une masse thermique quasi-infinie par rapport à la zone centrale 10.

Conformément à la représentation schématique de la figure 1, les poutres 14 présentent, conformément à l'état de l'art, des sections simplement rectangulaires ou trapézoïdales, d'épaisseur e, de largeur l. Une coupe II-II transversale de la poutre 14 est représentée à plus grande échelle à la figure 2, en précisant ces dimensions.

Les poutres qui peuvent elles-mêmes être considérées comme des éléments de microstructure flottants comportent une ou plusieurs couches empilées de matériau. Leur résistance thermique Rth peut être exprimée par l'équation suivante : $Rth=L/(\lambda_{eq}.l.e)$ ; $\lambda_{eq}$ étant la conductivité équivalente à l'ensemble des diverses couches avec leurs largeurs et épaisseurs respectives le long des poutres et L la longueur des poutres.

Pour augmenter la résistance thermique des poutres, il convient de choisir, si possible, des matériaux avec une conductivité thermique $\lambda$ minimum, de minimiser l'épaisseur e et la largeur l, quel que soit le dessin de détail de la poutre, et de maximiser la longueur L.

Ces contraintes mécaniques résultent en une détérioration de la robustesse des microbolomètres.

Le manque de robustesse se traduit, pour l'essentiel, par une sensibilité accrue aux diverses agressions mécaniques que la structure est susceptible de subir pendant ou après les dernières étapes de sa fabrication, et, en particulier, après la libération des parties flottantes par attaque de la couche sacrificielle. Le manque de robustesse se traduit également par une résistance moindre des structures aux accélérations et aux vibrations.

Les défauts de robustesse impliquent une diminution du rendement de fabrication, et donc un coût plus élevé des dispositifs de bolomètre et une limitation de leurs performances, en terme de rapport de signal sur bruit, et en termes de durée de vie.

Par ailleurs, lors de la fabrication des microstructures suspendues il est souvent nécessaire de contrôler avec une précision définie la position géométrique des divers éléments flottants, les uns par rapport aux autres. Ce contrôle suppose la connaissance au cours des opérations de fabrication de l'état des contraintes subies par les couches de matériau formant la microstructure.

En particulier, lorsqu'une microstructure est usinée dans un empilement formé de plusieurs couches de matériaux différents, un échauffement de la structure risque de produire un effet de "bilame" susceptible d'entraîner des déformations, des soulèvements ou des collages mécaniques préjudiciables pour les parties sensibles de la microstructure. D'autre part lorsqu'on enlève la couche sacrificielle, les contraintes contenues dans les autres couches se libèrent et sont alors susceptibles de produire les mêmes effets.

Dans le cas où la microstructure est une poutre, de longueur L, la résistance à la flexion est caractérisée par la flèche en bout de poutre sous l'application d'une force F en l'extrémité libre de la poutre, perpendiculairement à sa longueur, l'autre extrémité, solidaire du substrat, étant maintenue rigidement. Suivant que la force F est appliquée de manière normale (perpendiculaire) ou parallèle au plan du substrat, la flèche normale ($f_n$) ou parallèle ($f_p$) est de la forme :

$$f_n = F \cdot L^3/3M \cdot I_n$$

$$f_p = F \cdot L^3/3M \cdot I_p$$

où M est le module de Young de flexion du matériau constituant la poutre, supposée homogène pour des raisons de simplification, et où $I_n$ et $I_p$ sont respectivement les moments d'inertie de la section droite de la poutre (par exemple 14 sur la figure 1) par rapport aux axes respectivement normaux et parallèles au plan du substrat, passant par l'axe géométrique de la poutre.

Dans le cas d'une poutre de section rectangulaire d'épaisseur e et de largeur l, les moments d'inertie s'expriment par $I_n = 1.e^3/12$ et $I_p=e.l^3/12$. Les flèches sont donc de la forme :

$$f_n = \frac{4F}{M} \cdot \frac{L^3}{l.e^3}$$

et

$$f_p = \frac{4F}{M} \cdot \frac{L^3}{e.l^3}$$

Dans le cas d'un microbolomètre on recherche à la fois une bonne rigidité des poutres et une forte résistance thermique.

Les résistances à la flexion et à la rupture des poutres de support diminuent donc extrêmement vite lorsqu'on cherche à maximiser la résistance thermique, c'est-à-dire lorsqu'on cherche à réduire la largeur et/ou l'épaisseur des poutres, et/ou à augmenter leur longueur.

Un but de la présente invention est de proposer un procédé de fabrication d'éléments de microstructures flottantes et rigides ne présentant pas les limitations évoquées ci-dessus.

Un autre but est de proposer un dispositif de micromécanique avec une structure flottante maintenue par des poutres, les poutres présentant des caractéristiques de rigidité améliorées. Un autre but encore est de proposer des poutres pour la suspension de la zone sensible d'un microbolomètre, qui présentent une bonne rigidité, une bonne résistance à la torsion, qui sont conductrices électriques pour transférer des signaux, et qui ont une résistance thermique $R_{th}$ élevée.

Exposé de l'invention

Pour atteindre les buts mentionnés ci-dessus, l'invention a plus précisément pour objet un procédé de fabrication d'au moins un élément de microstructure flottante rigide usinée dans un substrat comportant un empilement d'une couche de support, d'au moins une couche de matériau sacrificiel et d'au moins une couche dite de structure, caractérisé en ce qu'il comporte les étapes suivantes :

a) formation d'au moins une structure en relief avec des flancs latéraux par gravure de la couche de structure et d'au moins une partie de la couche de matériau sacrificiel, selon un motif de gravure correspondant à l'élément de microstructure flottante,
b) formation d'une garniture dite de rigidité sur les flancs latéraux,
c) élimination du matériau sacrificiel de chaque structure en relief pour libérer la microstructure flottante comportant la couche de structure et la garniture de rigidité.

L'élément de microstructure se compose ainsi de la (ou des) couche(s) de structure et de la garniture de rigidité qui en augmente la résistance à la flexion et à la torsion. La rigidité accrue de l'élément de microstructure permet de réduire l'épaisseur et/ou la largeur en particulier de la (ou des) couche(s) de structure et ainsi d'en augmenter la résistance thermique.

Selon une variante du procédé pour la fabrication d'un élément de microstructure dans un substrat comportant en outre une deuxième couche de matériau sacrificiel et une deuxième couche de structure empilées dans cet ordre entre la couche de support et la première couche de matériau sacrificiel, la formation d'une structure en relief avec des flancs latéraux comporte en outre la gravure de la deuxième couche de structure et d'au moins une partie de la deuxième couche de matériau sacrificiel, et la première couche de structure est éliminée après la formation de la couche de rigidité sur les flancs latéraux.

Selon une autre variante du procédé, pour la fabrication d'un élément de microstructure dans un substrat ayant en alternance deux couches de structures et deux couches de matériau sacrificiel comme indiqué ci-dessus, le procédé peut en outre comporter entre les étapes a) et b) la gravure de la deuxième couche de structure et d'au moins une partie de la deuxième couche sacrificiel selon le motif correspondent à l'emplacement des poutres, puis l'élimination de la première couche de structure.

Selon la variante du procédé mis en oeuvre et selon la structure du substrat, il est possible de réaliser différents types de microstructures rigides qui se distinguent en particulier par la disposition de la garniture de rigidité par rapport à la couche de structure.

De même selon que la gravure de la première ou de la première et de la deuxième couches de matériau sacrificiel est anisotrope ou isotrope, il est possible de modifier la forme de la garniture de rigidité et donc de jouer sur ses propriétés mécaniques.

La présente invention prévoit donc les différents cas où les gravures de la première couche de matériau sacrificiel et celle de la deuxième couche de matériau sacrificiel sont isotrope ou anisotropes.

Selon un aspect particulier de l'invention, il est possible de former, préalablement à l'étape a) du procédé, un masque définissant le motif de gravure. Ce masque peut être éliminé, par exemple, avant la formation de la garniture de rigidité. De façon avantageuse, il est aussi possible de n'éliminer le masque qu'après la formation de la garniture de rigidité. Dans ce dernier cas, le masque fait partie de la structure en relief sur les flancs de laquelle est formée la garniture.

La présente invention concerne aussi un dispositif de micromécanique comportant un substrat de support, une structure flottante séparée du substrat et au moins une poutre de suspension reliant la structure flottante au substrat, caractérisé en ce que la poutre présente des bords latéraux équipés de garnitures de rigidité s'étendant le long des bords de la poutre et, au delà des bords, dans des directions sensiblement perpendiculaires à l'axe de la poutre.

La poutre, équipée des garnitures présente ainsi une section sensiblement en U ou en H qui lui confère une meilleure rigidité.

Selon un aspect particulier de la réalisation d'un tel dispositif, la poutre peut comporter un empilement alterné d'au moins une couche de matériau électriquement conducteur et d'au moins une couche de matériau électriquement isolant.

Dans une application particulière de l'invention, la structure flottante du dispositif est la partie sensible d'un microbolomètre.

Cette structure flottante peut également être équipée sur ses bords latéraux de garnitures de rigidité, par exemple sous la forme d'un cadre de rigidité.

D'autres caractéristiques et avantages de la présente invention ressortiront mieux de la description qui va suivre, en référence aux figures annexées, donnée à titre purement illustratif et non limitatif.

Brève description des figures

- la figure 1, déjà décrite, est une vue schématique de dessus d'un microbolomètre d'un type connu,
- la figure 2, déjà décrite, est une coupe transversale II-II à plus grande échelle d'une poutre de suspension de la partie sensible de détection du microbolomètre de la figure 1,
- les figures 3 à 4A, 5A, 6A et 7A illustrent en coupe les étapes de fabrication d'un élément de microstructure conformément à un premier mode de mise en oeuvre de l'invention,
- les figures 4B, 5B, 6B, 7B illustrent en coupe les étapes de fabrication d'un élément de microstructure conformément à une variante du premier mode de mise en oeuvre de l'invention,
- les figures 8, 9A, 10A, 11A, 12A et 13A illustrent en coupe les étapes de fabrication d'un élément de microstructure conformément à un deuxième mode de mise en oeuvre de l'invention,
- les figures 9B, 11B, 12B et 13B illustrent en coupe les étapes de fabrication d'un élément de microstructure conforme à une variante du deuxième mode de mise en oeuvre de l'invention,

- les figures 14 à 18 illustrent en coupe les étapes de fabrication d'un élément de microstructure conformément à un troisième mode de mise en oeuvre de l'invention,

- les figures 19 à 23 illustrent en coupe les étapes de fabrication d'un élément de microstructure conformément à un quatrième mode de mise en oeuvre de l'invention,

- les figures 24 à 27 illustrent en coupe les étapes de fabrication d'un élément de microstructure conformément à un cinquième mode de mise en oeuvre de l'invention,

- les figures 28 à 32 illustrent en coupe les étapes de fabrication d'un élément de microstructure conformément à un sixième mode de mise en oeuvre de l'invention.

<u>Description détaillée de modes de mise en oeuvre de l'invention</u>

Dans la description qui suit des références identiques sont attribuées à des éléments ou parties identiques ou similaires des différentes figures.

**EXEMPLE 1**

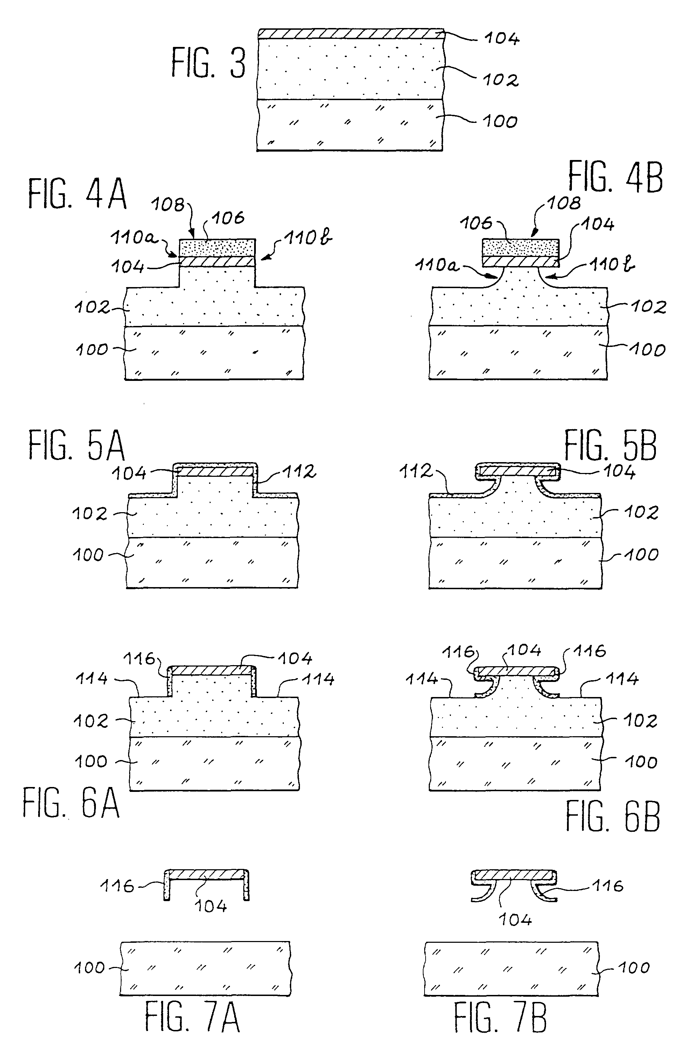

Un premier exemple de mise en oeuvre du procédé de l'invention est illustrée par les figures 3 à 7. Deux variantes très proches de mise en oeuvre du procédé sont expliquées dans le cadre de l'exemple 1. Elles sont distinguées par les numéros de figure terminant par A, respectivement par B. Les numéros de figures ne terminant ni par A, ni par B s'appliquant indifféremment aux deux variantes.

La figure 3 montre la fabrication d'un substrat pour mise en oeuvre du procédé de l'invention selon un premier mode. Sur une couche de support 100, on dépose une première couche de matériau sacrificiel 102 puis une ou plusieurs couches de matériau qui forment une première couche 104, dite "de structure" dans laquelle sont, par la suite, usinées la ou les microstructures. La couche 104 peut être par exemple une couche de silicium, d'oxyde silicium, de nitrure de silicium, de métal ou d'une superposition de couches de matériaux précédemment cités.

La couche de support 100 peut servir également de substrat pour la fabrication d'un circuit ou d'éléments d'un circuit de microélectronique, dont la fonction, de mesure par exemple, est associée à la structure de micromécanique réalisée dans la couche 104. Ce circuit de mesure n'est pas représenté sur les figures pour des raisons de clarté.

La couche sacrificielle 102 peut être réalisée en un matériau tel que, par exemple, l'oxyde de silicium ou un matériau organique tel que le polyimide.

Une étape suivante du procédé est la mise en forme de la couche 104 selon un motif de gravure. Ce motif peut être, par exemple, conformé à la forme de la partie sensible d'un microbolomètre comportant des poutres appelés bras de support, tel que représenté à la figure 1.

Le motif de gravure est défini par un masque de résine 106 déposé sur la couche 104. Les parties de la couche 104 non protégées par le masque 106 sont ensuite éliminées par gravure.

La couche de matériau sacrificiel est également soumise à une gravure lors de laquelle ses parties non protégées par le masque 106 ou par la couche 104 restante sont éliminées en partie. Cette étape est illustrée aux figures 4A et 4B. On obtient ainsi une structure en relief 108, selon le motif de gravure, c'est-à-dire selon le motif de l'élément de microstructure que l'on souhaite réaliser. La structure en relief 108, présente un ou des flancs latéraux 110a, 110b.

Les figures 4A et 4B montrent la structure en relief 108 obtenue respectivement avec une gravure anisotrope de la couche 102 de matériau sacrificiel et avec une gravure isotrope de cette couche. Dans le cas de la figure 4B les flans 110a et 110b présentent des évidements s'étendant localement sous la couche 104.

Dans le cas où la couche 102 est en oxyde de silicium, une gravure isotrope peut être effectuée par une attaque à l'acide fluorhydrique FH en phase aqueuse ou en phase vapeur. Une gravure anisotrope peut être une gravure ionique réactive de type RIE (Reactive Ion Etching) avec des fluorocarbones gazeux de type $CHF_3$, $C_2F_6$, par exemple.

Dans le cas où la couche sacrificielle 102 est en un matériau organique, par exemple en polyimide, une gravure isotrope peut être effectuée à l'aide d'un plasma d'oxygène ou par exposition de la couche à de l'ozone. Une gravure anisotrope peut être une gravure réactive également du type RIE avec les gaz $O_2$ ou un mélange $O_2+SF_6$. On peut noter que dans le cas d'une gravure isotrope ou anisotrope de la couche de matériau sacrificiel dans les conditions ci-dessus, le masque de résine 106 est également éliminé, au moins partiellement.

Après élimination du masque 106, on forme, comme le montrent les figures 5A et 5B, une (ou plusieurs) couche(s) de matériau 112 qui recouvre(nt) notamment les flancs 110a et 110b de la structure en relief. La couche 112 recouvre l'ensemble des surfaces libres de la façon la plus conforme et la plus uniforme possible.

Il s'agit, par exemple, d'une couche de silicium, d'oxyde de silicium SiO ou de nitrure de silicium SiN obtenue à basse température selon une technique de dépôt activé par plasma du type PECVD (Plasma Enhanced Chemical Vapor Deposition). Une couche de nitrure de silicium peut aussi être formée par dépôt chimique en phase vapeur à basse pression selon une technique de type LPCVD (Low Pressure Chemical Vapor Deposition). Un tel dépôt est effectué à plus haute température, de 600 à 750°C avec des mélanges d'ammoniac et de dichlorosilane. La technique de LPCVD peut aussi être utilisée pour former une couche 112 en oxyde de silicium. Dans ce cas, le dépôt peut être effectué à des températures de 850 à 950°C avec des mélanges de dichlorosilane et de protoxyde d'azote, ou à des températures de 600 à 750°C avec des précurseurs de type "TEOS" (tétraéthoxysilane). Ces matériaux présentent en outre, notamment lorsqu'ils sont formés par LPCVD, une bonne conformité de couverture de la structure en relief.

La couche 112 qui recouvre la structure en relief peut également être une couche de silicium. Le silicium peut être formé selon la technique dite LPCVD, à une température de 250 à 500°C avec une source de disilane ou à une température de 550 à 700°C avec une source de silane. Le silicium peut être ou non dopé, par exemple, par adjonction ou non de diborane ou de phosphine lors de sa formation. Lorsque le silicium est déposé à basse température, c'est-à-dire à une température inférieure à 560°C, la couche 112 est amorphe ; au-dessus de 600°C la couche 112 est polycristalline.

Si on veut réaliser un élément de microstructure avec une faible conductivité thermique, la couche 112 est réalisée préférentiellement en silicium amorphe non dopé.

L'oxyde de silicium SiO et le nitrure de silicium SiN présentent de bonnes caractéristiques d'isolement thermique. Leur conductance est de l'ordre de 2 à 3 W/m.K.

Si on veut réaliser un élément de microstructure présentant des caractéristiques métalliques, la couche 112 est réalisée par exemple, en tungstène, en titane ou en nitrure de titane par dépôt LPCVD par exemple.

La couche 112 peut être composée d'un seul matériau ou être une combinaison de plusieurs sous-couches de matériaux différents, ces matériaux étant choisis en fonction des caractéristiques mécaniques ou électriques recherchées pour l'élément de microstructure à réaliser. La couche 112 peut comporter par exemple une sous-couche diélectrique d'oxyde de silicium et une sous-couche de silicium.

Dans le présent exemple, la couche 112 est composée d'un matériau pouvant être déposé sur la résine. Sa température de dépôt doit être alors inférieure à 180°C.

Comme le montrent les figures 6A et 6B une gravure anisotrope sans masque permet d'éliminer la partie de la couche 112 recouvrant la couche 104 et recouvrant les parties 114 de la couche sacrificielle de part et d'autre de la structure en relief.

Lors de cette gravure seules les parties de la couche 112 recouvrant les flancs 110a et 110b de la structure en relief sont préservées. Ces parties sont désignées dans la suite par "garnitures de rigidité" et portent la référence 116.

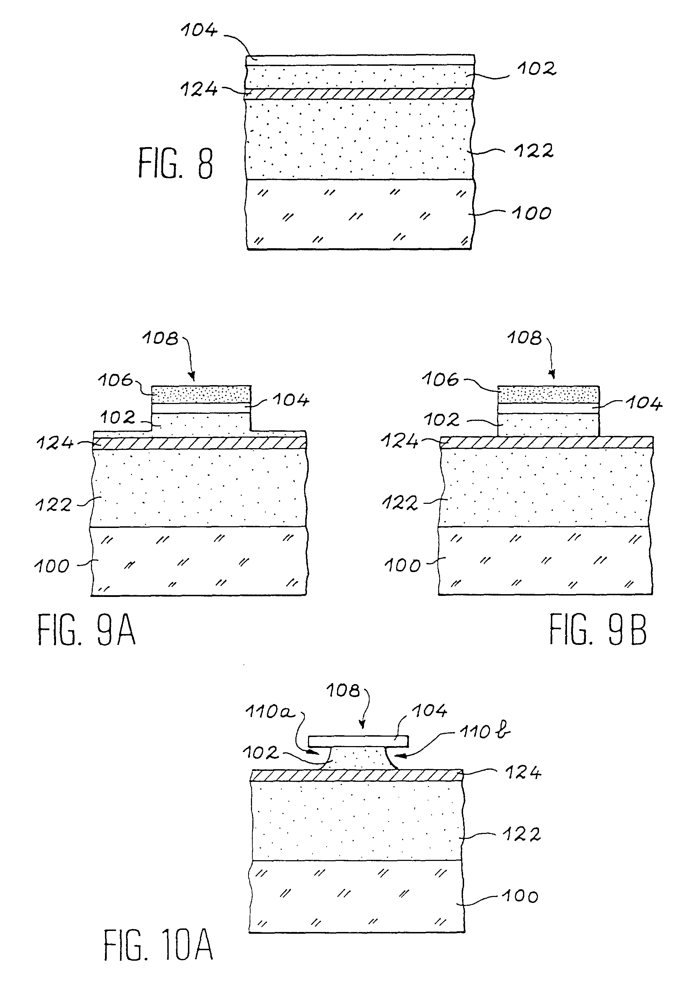

Le matériau sacrificiel de la couche 102 est ensuite éliminé comme le montrent les figures 7A et 7B.

L'élément de microstructure est ainsi libéré par rapport au substrat 100. Il est composé de la couche 104 et de la garniture de rigidité 116.

## EXEMPLE 2

Une variante de mise en oeuvre est illustrée par les figures 8 à 13.

Cette mise en oeuvre de l'invention concerne la fabrication d'une microstructure flottante dans un substrat avec deux couches de structure et deux couches de matériau sacrificiel.

Comme le montre la figure 8, on forme un substrat en déposant successivement sur une couche de support 100, une couche de matériau sacrificiel 122, désignée par "deuxième couche de matériau sacrificiel", une couche 124 de matériau de structure, désignée par "deuxième couche de structure", une couche de matériau sacrificiel 102, désignée par "première couche de matériau sacrificiel", et une couche de structure 104 désignée par "première couche de structure".

Comme dans le cas de l'exemple 1, les couches sacrificielles 102, 122 peuvent être réalisées en oxyde de silicium ou en polyimide par exemple. Les couche de structure 104, 124 sont par exemple en oxyde de silicium.

Après la formation d'un masque de gravure 106 définissant la forme de la microstructure à réaliser, on effectue successivement une gravure anisotrope de la première couche de structure 104 et de la première couche de matériau sacrificiel 102 dans des régions non protégées par le masque 106.

On obtient ainsi une structure en relief 108 conforme aux illustrations des figures 9A et 9B.

Dans ces régions non protégées, la couche 104 est totalement éliminée et la couche 102 est éliminée soit totalement (figure 9B) soit partiellement (figure 9A) .

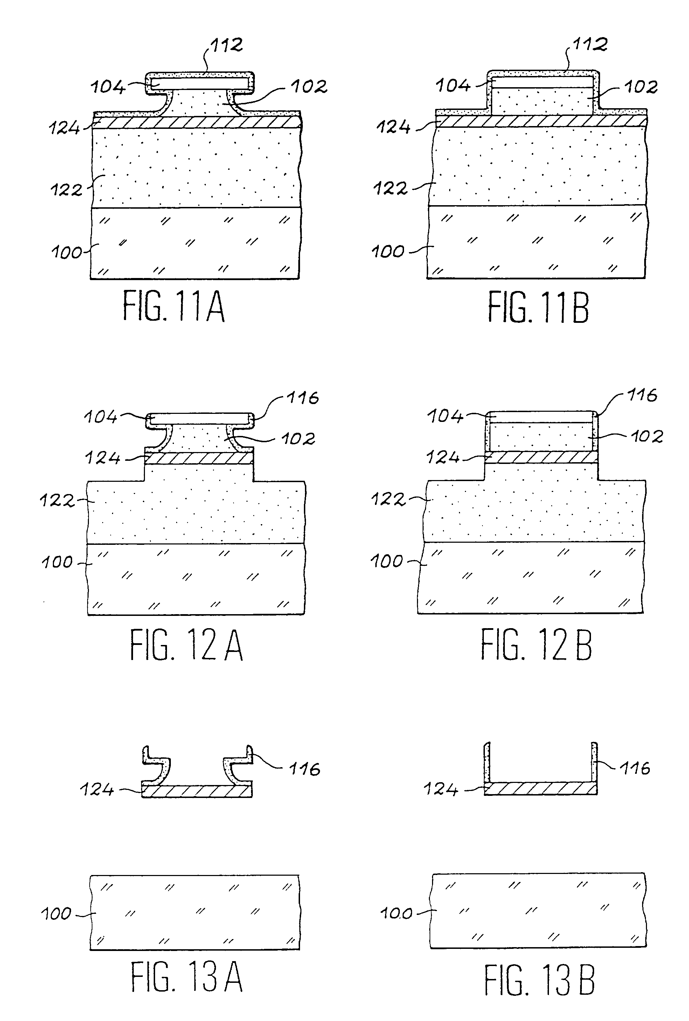

La gravure anisotrope de la première couche sacrificielle 102 peut être complétée, comme le montre la figure 10A, par une gravure isotrope de la couche 102. Ceci a pour effet de former des évidements s'étendant le long des flancs 110a et 110b de la structure 108.

Après l'élimination du masque 106, comme dans le cas de l'exemple 1, les structures 108 en relief ainsi obtenues sont recouvertes avec une couche 112, ou une pluralité de couches 112. La formation de la couche 112, visible sur les figures 11A et 11B est conforme à la description donnée pour l'exemple 1.

Une gravure anisotrope sans masque élimine la couche 112 au-dessus de la première couche de structure 104 et sur les parties 114 de la couche sacrificielle. La couche 112 n'est préservée que sur les flancs 110a et 110b où elle forme la garniture de rigidité 116. Comme le montrent les figures 12A et 12B la deuxième couche de structure 124 est également gravée. Cette gravure n'est pas nécessairement une gravure sélective. Ainsi, comme le montrent les figures 12A et 12B, la couche 122 peut également être légèrement attaquée. Lors de cette gravure, la première couche 104 sert de masque de gravure.

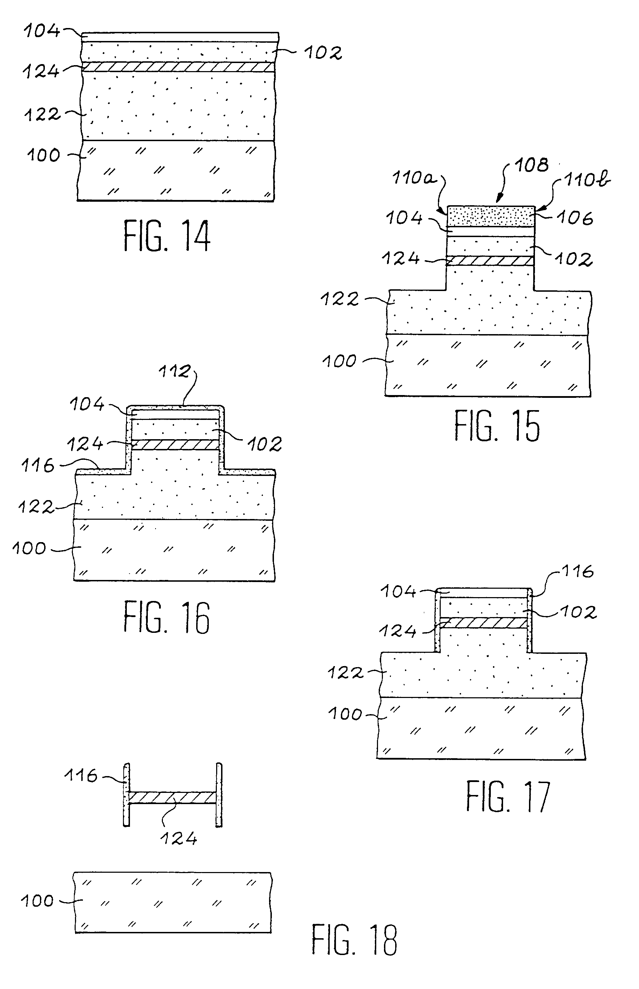

De préférence, on effectue une gravure anisotrope qui permet simultanément de mettre en forme les garnitures de rigidité et de graver la couche 124. Après l'élimination de la première couche de structure, on élimine aussi le matériau restant des première et deuxième couches sacrificielles 102 et 122 pour obtenir un élément de microstructure flottant avec une section en U, conforme à l'une des figures 13A et 13B. Celui-ci comporte une partie de la couche 124, formant, par exemple, une poutre de suspension de la partie sensible d'un microbolomètre, et les garnitures de rigidités 116. Selon que l'on ait effectué ou non une gravure isotrope de la première couche sacrificielle 102, on obtient une structure de rigidité avec une section formée (Fig. 13A) ou droite (Fig. 13B).

## EXEMPLE 3

Un autre exemple de mise en oeuvre de l'invention est illustré par les figures 14 à 18. Le substrat de base utilisé dans cet exemple, est, comme le montre la figure 14, identique au substrat utilisé dans le cas de l'exemple 2.

Celui-ci comporte ainsi une couche de support 100, une (première) couche de matériau sacrificiel 102, une (première) couche de structure 104, une (deuxième) couche de matériau sacrificiel 122 et une (deuxième) couche de structure 124.

Après la formation d'un masque 106 qui définit la forme de l'élément de microstructure que l'on souhaite réaliser on effectue une ou plusieurs attaques afin de graver, en dehors de la région protégée par le masque, la première et la deuxième couches de structure 104, 124, la première couche de matériau sacrificiel 102 et au moins une partie de la deuxième couche de matériau sacrificiel 122 de façon à créer une marche.

On obtient après gravure une structure en relief 108 avec des flancs latéraux 110a, 110b telle que représentée à la figure 15.

Après élimination du masque on forme une (ou plusieurs) couche(s) 112 qui recouvre(nt) la structure en relief (figure 16). Comme dans le cas des exemples 1 et 2, la couche 112 subit une gravure anisotrope sans masque pour mettre en forme sur les flancs de la structure en relief des garnitures de rigidité 116, représentées à la figure 17.

Dans une dernière étape, on élimine la première couche de structure et le matériau sacrificiel des couches 102 et 122. On obtient ainsi un élément de microstructure avec une section en H conforme à la figure 18.

La barre centrale de la section en H est formée par la deuxième couche de structure 124 et les barres perpendiculaires à la barre centrale par les garnitures de rigidité 116.

## EXEMPLE 4

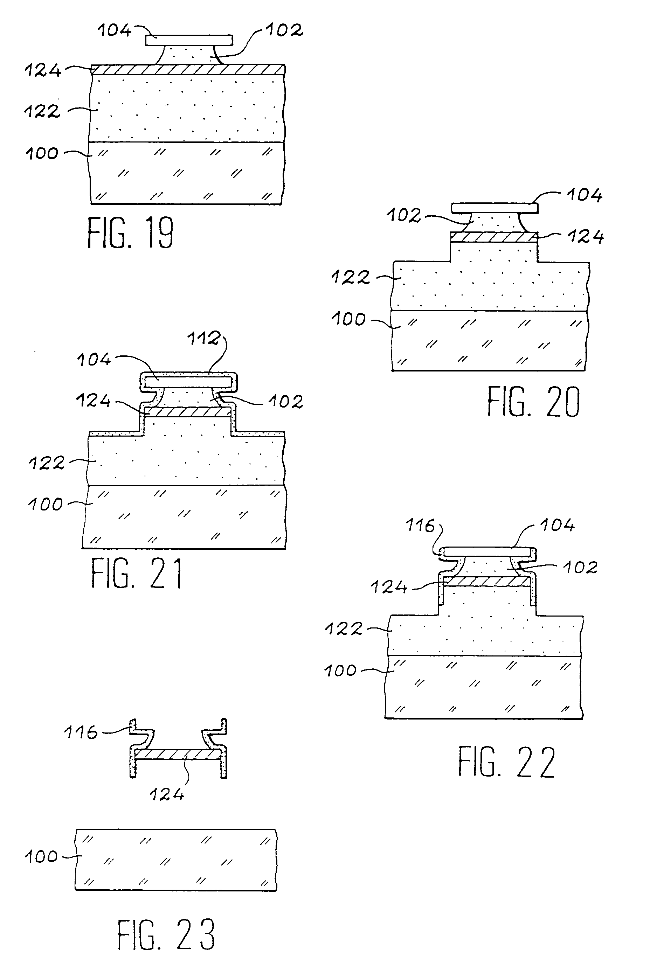

Les figures 19 à 23 montrent un autre exemple de mise en oeuvre du procédé à partir d'un substrat semblable à celui des figures 8 ou 14.

La figure 19 correspond à la figure 10A de l'exemple 2 dans laquelle la première couche de structure 104 et la première couche de matériau sacrificiel 102 sont mises en forme selon un motif correspondant à l'élément de microstructure que l'on souhaite réaliser. La gravure de la couche de matériau sacrificiel est une gravure isotrope.

La formation d'une structure en relief 108 se poursuit comme le montre la figure 20 par la gravure anisotrope de la deuxième couche de structure 124 et d'au moins une partie de la deuxième couche sacrificielle 122 selon le motif de gravure. Lors de cette gravure la première couche de structure sert de masque.

Comme dans le cas de l'exemple 3, la fabrication de l'élément de microstructure se poursuit par la formation d'une couche 112 (figure 21), la mise en forme de cette couche pour obtenir des garnitures de rigidité 116 sur les flancs de la structure en relief (figure 22) et l'élimination de la première couche de structure puis du matériau sacrificiel restant des couches 102 et 122.

On obtient un élément de microstructure avec une section sensiblement en H, illustrée à la figure 23.

## EXEMPLE 5

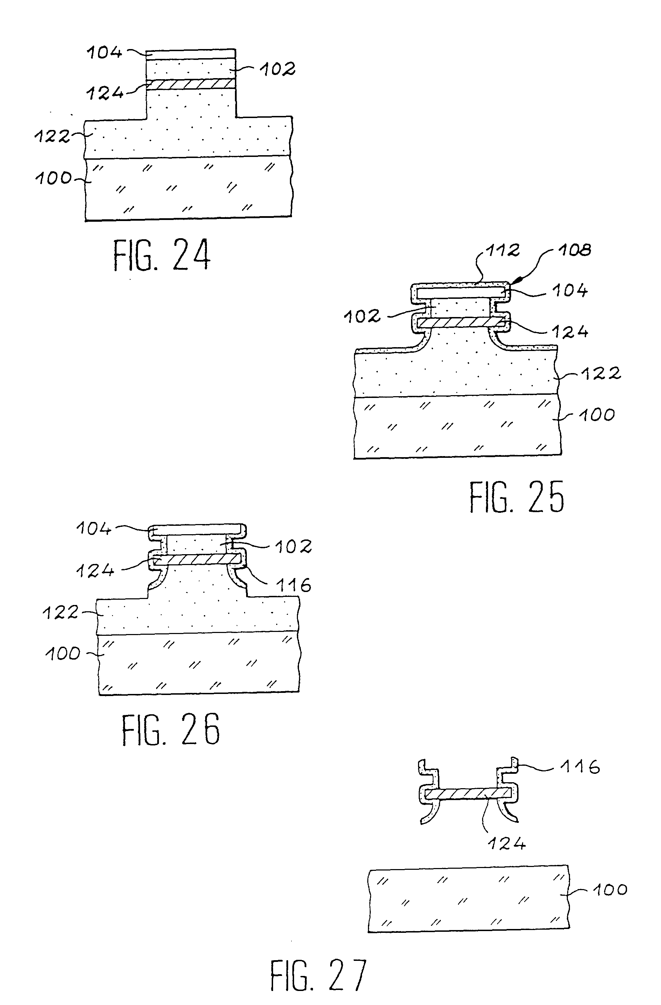

La structure de départ correspondant à l'exemple 5 est illustré à la figure 24. A l'exception du masque de gravure qui est éliminé, cette figure est conforme à la figure 15, déjà décrite, et on peut se reporter à l'exemple 3 pour les étapes de la réalisation de la structure en relief que montre cette figure.

Avant la formation d'une couche de recouvrement 112 sur les flancs 110a, 110b de la structure en relief 108, les flancs sont, comme le montre la figure 25, soumis à une gravure isotrope pour mettre en retrait les parties 102 et 122 des couches de matériau sacrificiel sous les couches de structure.

Les figures 26 et 27 montrent respectivement la gravure anisotrope de la couche 112 pour former les garnitures de rigidité 116 (figure 26), et l'élimination de la première couche de structure 104 et du matériau restant des couches sacrificielles 102 et 122 (figure 27). On obtient également un élément de microstructure avec une section sensiblement en H dont les barres latérales sont formées.

## EXEMPLE 6

Dans les exemples 1 à 5, la couche de résine formant le masque ne fait pas à proprement dit partie de la structure en relief tel qu'elle est utilisée pour la réalisation des garnitures de rigidité. Le masque est éliminé avant la formation de la couche 112.

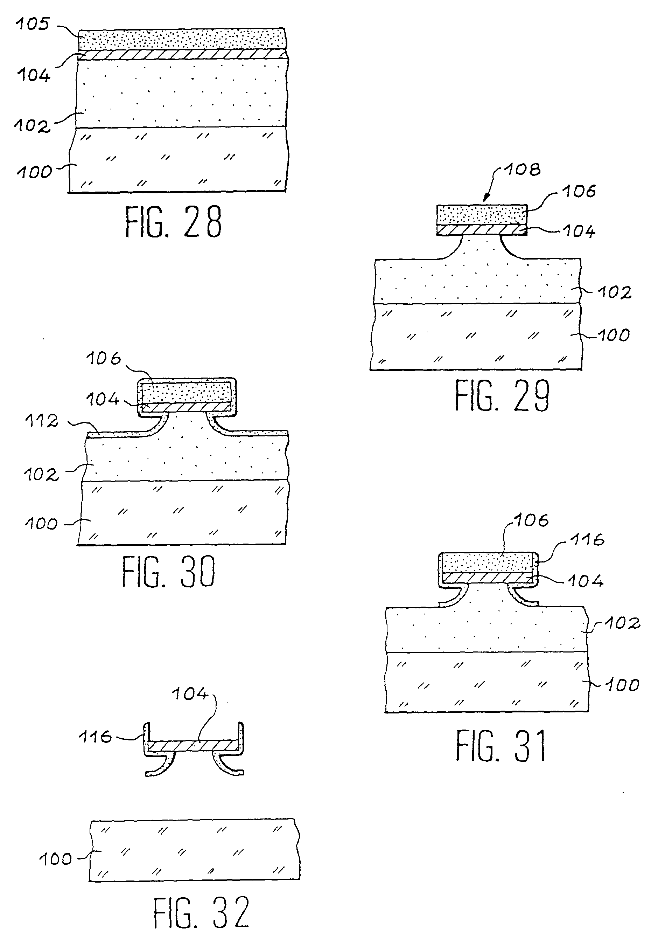

Dans un mode de réalisation correspondant aux figures 28 à 32, le masque de résine est au contraire mis à profit. Comme le montre la figure 29, on forme un substrat en déposant successivement sur une couche de support 100 une couche de matériau sacrificiel 102, une couche de structure 104 et une couche de résine 105. Pour le choix des matériaux des couches 100, 102 et 104, on peut se reporter à l'exemple 1. La couche de résine sert à la fabrication d'un masque de gravure déjà décrit.

La figure 29 montre la mise en forme d'une structure en relief 108 par gravure de la couche de structure 104 et la gravure partielle de la couche de matériau sacrificiel 102, selon le motif d'un masque de gravure 106 réalisé dans la couche de résine 105. La gravure de la couche 102 est de type isotrope. Après cette gravure le masque 106 est maintenu ; il fait partie de la structure en relief 108.

Comme le montre la figure 30, une couche de recouvrement est formée autour de la structure en relief 108. Puis, cette couche est gravée pour former les garnitures de rigidité 116 visibles à la figure 31. Lors de cette gravure, la résine formant le masque 106 est mise à nu.

La résine du masque 106 ainsi que le matériau de la couche sacrificielle 102 sont enfin éliminés pour libérer un élément de microstructure représenté à la figure 32.

Quel que soit l'exemple choisi, l'élément de microstructure peut être par exemple une partie d'un dispositif de micromécanique tel que par exemple une zone centrale 10 et les poutres de suspension 14 d'un microbolomètre tel que représenté à la figure 1.

Toutefois, l'élément de microstructure réalisé conformément à l'invention peut n'être qu'une partie d'un tel dispositif. Il ne s'agit par exemple que des poutres de suspension.

Les poutres de suspension réalisées conformément à l'invention, c'est-à-dire avec des garnitures de rigidité s'étendant le long de leurs bords latéraux présentent une bonne rigidité et ne se vrillent pas. A titre indicatif, les bords latéraux des poutres sont repérés avec la référence 130 sur la figure 1. Ces poutres présentent une section en U ou en H avec des garnitures latérales droites ou éventuellement nervurées. Différentes sections possibles sont représentées aux figures 7A, 7B, 13A, 13B, 18, 27 et 32.

D'autre part, dans le cas de microbolomètres, la partie centrale (voir référence 10 de la figure 1) est une membrane et il est intéressant de l'équiper également de garnitures latérales de rigidité formant à sa périphérie un cadre. Un tel cadre permet de limiter les déformations, et en particulier le gauchissement, de la partie centrale.

Dans des réalisations particulières de telles poutres la couche de structure peut comporter, par exemple une ou plusieurs couches de matériau conducteur électrique qui joue un rôle d'électrode pour transmettre des signaux électriques de la partie centrale d'un bolomètre vers des circuits de mesure périphériques.

Dans le cas où la partie centrale de la poutre (couche de structure) est constituée de deux couches de matériaux conducteurs électriques séparés par un isolant, il peut se produire des fuites électriques entre les deux matériaux conducteurs. Ces fuites peuvent être évitées en réalisant une garniture de rigidité qui comporte des parties en un matériau isolant au moins dans les zones en contact avec les matériaux conducteurs.

**Revendications**

1. Procédé de fabrication d'au moins un élément de microstructure flottant rigide (104, 116) usiné dans un substrat comportant un empilement d'une couche de support (100), d'au moins une couche (102) de matériau sacrificiel et d'au moins une couche dite de structure (104), **caractérisé en ce qu'**il comporte les étapes suivantes :

   a) formation d'au moins une structure en relief (108) avec des flancs latéraux (110a, 110b) par gravure de la couche de structure (104) et par gravure d'au moins une partie de la couche de matériau sacrificiel (102), selon un motif de gravure correspondant à l'élément de microstructure flottante,
   b) formation d'une garniture dite de rigidité (116) sur les flancs latéraux (110a, 110b),
   c) élimination du matériau sacrificiel de chaque structure en relief (108) pour libérer la microstructure flottante comportant la couche de structure (104) et la garniture de rigidité (116).

2. Procédé de fabrication d'une microstructure flottante selon la revendication 1 dans un substrat comportant en outre une deuxième couche de matériau sacrificiel (122) et une deuxième couche de structure (124) empilées dans cet ordre entre la couche de support (100) et la première couche de matériau sacrificiel (102), dans lequel la formation d'une structure en relief (108) avec des flancs latéraux (110a, 110b) comporte en outre la gravure de la deuxième couche de structure (124) et d'au moins une partie de la deuxième couche de matériau sacrificiel (122), et dans lequel la première couche de structure (104) est éliminée après la formation de la garniture de rigidité (116) sur les flancs latéraux (110a, 110b).

3. Procédé de fabrication d'une microstructure flottante selon la revendication 1, dans un substrat comportant en outre une deuxième couche de structure (124) et une deuxième couche de matériau sacrificiel (122) empilées dans cet ordre entre la couche de support (100) et la première couche de matériau sacrificiel (102), le procédé comportant en outre entre les étapes a) et b) la gravure de la deuxième couche de structure (124) et la gravure d'au moins une partie de la deuxième couche sacrificielle (122) selon le motif correspondant à l'élément de microstructure flottant puis l'élimination de la première couche (104) de structure.

4. Procédé selon l'une des revendications 1 à 3, **caractérisé en ce que** la gravure de la couche de matériau sacrificiel (102) est une gravure anisotrope.

5. Procédé selon l'une quelconque des revendications 2 à 4, **caractérisé en ce que** la gravure de la seconde couche de matériau sacrificiel (124) est une gravure anisotrope.

6. Procédé selon l'une des revendications 1 à 3, **caractérisé en ce que** la gravure de la couche de matériau sacrificiel (102) est une gravure isotrope.

7. Procédé selon l'une quelconque des revendications 2 à 4, **caractérisé en ce que** la gravure de la seconde couche de matériau sacrificiel est une gravure isotrope.

8. Procédé selon la revendication 1, **caractérisé en ce que** préalablement à l'étape a), on forme sur la couche de structure (104) un masque (106) définissant le motif de gravure.

9. Procédé selon la revendication 8, **caractérisé en ce qu'**on élimine le masque (106) avant la formation de la garniture de rigidité (116).

10. Procédé selon la revendication 8, **caractérisé en ce qu'**on élimine le masque (106) après la formation de la garniture de rigidité (116), le masque faisant partie de la structure en relief (108) avec des flancs latéraux (110a, 110b).

11. Procédé selon la revendication 1, **caractérisé en ce que** la formation de la garniture de rigidité (116) comporte le dépôt d'au moins une couche de matériau (112) recouvrant chaque structure en relief (108), et la gravure anisotrope sans masquage de cette couche (112).

12. Procédé selon la revendication 1, **caractérisé en ce que**. pour la formation de la garniture de rigidité (116) on choisit au moins l'un des matériaux parmi le nitrure de silicium, l'oxyde de silicium et le silicium ou un métal.

13. Procédé de fabrication de poutres de suspension d'une partie suspendue d'un dispositif de micromécanique, **caractérisé en ce que** les poutres sont réalisées conformément au procédé de la revendication 1.

14. Dispositif de micromécanique comportant un substrat de support (100), une structure flottante séparée du substrat et au moins une poutre de suspension reliant la structure flottante au substrat, **caractérisé en ce que** la poutre présente des bords latéraux (130) équipés garnitures de rigidité (116) s'étendant le long des bords de la poutre et, au delà des bords, dans des directions sensiblement perpendiculaire à l'axe de la poutre.

15. Dispositif selon la revendication 14, **caractérisé en ce que** la structure flottante présente également des bords latéraux équipés de garnitures de rigidité, lesdites garnitures de rigidité formant un cadre.

16. Dispositif selon la revendication 14, **caractérisé en ce que** la poutre comporte au moins une couche de matériau choisi parmi les matériaux suivants : silicium, oxyde de silicium, nitrure de silicium et métal.

17. Dispositif selon la revendication 14, **caractérisé en ce que** la poutre comporte un empilement alterné d'au moins une couche de matériau électriquement conducteur et d'au moins une couche de matériau électriquement isolant.

18. Dispositif selon la revendication 17, **caractérisé en ce que** les garnitures de rigidité comportent des parties en un matériau isolant électrique au moins dans des zones en contact avec ladite couche de matériau électriquement conducteur de l'empilement.

19. Dispositif selon la revendication 14, **caractérisé en ce que** les garnitures sont en un matériau choisi parmi l'oxyde de silicium, le nitrure de silicium, le silicium et les métaux.

20. Dispositif selon la revendication 14, **caractérisé en ce que** la structure flottante est la partie sensible d'un microbolomètre.

**Claims**

1. Method of manufacturing at least one rigid floating microstructure element (104, 116) machined in a substrate comprising a stacking of a support layer (100), at least one sacrificial material layer (102) and at least one so-called structure layer (104), **characterized in that** it comprises the following steps:

   a) formation of at least one relief structure (108) with lateral sides (110a, 110b) by etching the structure layer (104) and by etching at least a part of the layer (102) of sacrificial material, according to an etching pattern corresponding to the floating microstructure element,

b) formation of a so-called rigidity lining (116) on the lateral sides (110a, 100b),

c) removal of the sacrificial material from each relief structure (108) in order to release the floating microstructure comprising the structure layer (104) and the rigidity lining (116).

2. Method of manufacturing a floating microstructure according to claim 1 in a substrate comprising, in addition, a second layer (122) of sacrificial material and a second structure layer (124) stacked in this order between the support layer (100) and the first layer (102) of sacrificial material, in which the formation of a relief structure (108) with lateral sides (110a, 110b) comprises, in addition, the etching of the second structure layer (124) and at least a part of the second layer (122) of sacrificial material, and in which the first structure layer (104) is removed after the formation of the rigidity lining (116) on the lateral sides (110a, 110b).

3. Method of manufacturing a floating microstructure according to claim 1, in a substrate comprising a second structure layer (124) and a second layer (122) of sacrificial material stacked in that order between the support layer (100) and the first layer (102) of sacrificial material, the method comprising, in addition, between steps a) and b), the etching of the second structure layer (124) and the etching of at least a part of the second sacrificial layer (122) according to the pattern corresponding to the floating microstructure element and then the removal of the first structure layer (104).

4. Method according to any one of the claims 1 to 3, **characterized in that** the etching of the layer (102) of sacrificial material is an anisotropic etching.

5. Method according to any one of the claims 2 to 4, **characterized in that** the etching of the second layer (124) of sacrificial material is an

6. Method according to any one of the claims 1 to 3, **characterized in that** the etching of the first layer (102) of sacrificial material is an isotropic etching.

7. Method according to any one of the claims 2 to 4, **characterized in that** the etching of the second layer of sacrificial material is an isotropic etching.

8. Method according to claim 1, **characterized in that** prior to step a), a mask (106) defining the etching pattern is formed on the structure layer (104).

9. Method according to claim 8, **characterized in that** the mask (106) is removed before the formation of the rigidity lining (116).

10. Method according to claim 8, **characterized in that** the mask (106) is removed after the formation of the rigidity lining (116), the mask forming part of the relief structure (108) with the lateral sides (110a, 110b).

11. Method according to claim 1, **characterized in that** the formation of the rigidity lining (116) comprises the deposition of at least one layer (112) of material covering each relief structure (108), and the anisotropic etching of this layer (112) without masking.

12. Method according to claim 1, **characterized in that** for the formation of the rigidity lining (116) at least one of the materials among silicon nitride, silicon oxide and silicon or a metal, is chosen.

13. Method for the manufacture of suspension beams for a suspended part of a micro-mechanical device, **characterized in that** the beams are produced in accordance with the method of claim 1.

14. Micro-mechanical device comprising a support substrate (100), a floating structure separated from the substrate and at least one suspension beam connecting the floating structure to the substrate, **characterized in that** the beam has lateral edges (130) provided with rigidity linings (116) extending along the edges of the beam and, beyond the edges, in directions substantially perpendicular to the beam axis.

15. Device according to claim 14, **characterized in that** the floating structure also has lateral edges provided with rigidity linings, said rigidity linings forming a frame.

16. Device according to claim 14, **characterized in that** the beam comprises at least one layer of material chosen from among the following materials: silicon, silicon oxide, silicon nitride and a metal.

17. Device according to claim 14, **characterized in that** the beam comprises an alternating stacking of at least one layer of electrically conducting material and at least one layer of electrically insulating material.

18. Device according to claim 17, **characterized in that** the rigidity linings comprise parts made of an electrically insulating material at least in areas in contact with said layer of electrically conducting material in the stack.

**19.** Device according to claim 14, **characterized in that** the linings are made of a material chosen from among silicon oxide, silicon nitride, silicon and the metals.

**20.** Device according to claim 14, **characterized in that** the floating structure is the sensitive part of a micro-bolometer.

**Patentansprüche**

**1.** Herstellungsverfahren mindestens eines starren "schwimmenden" bzw. frei beweglichen Mikrostrukturelements (104, 116), das in einem Substrat gefertigt wird, welches einen Stapel bzw. eine Schichtung einer Trägerschicht (100), mindestens einer Opfermaterialschicht (102) und mindestens einer sogenannten Strukturschicht (104) aufweist, **dadurch gekennzeichnet, daß** es folgende Schritte umfaßt:

a) Ausbilden mindestens einer Reliefstruktur (108) mit seitlichen Flanken (110a, 110b) durch Ätzen der Strukturschicht (104) und durch Ätzen mindestens eines Teils der Opfermaterialschicht (102) gemäß einem Ätzmuster, das dem frei beweglichen Mikrostrukturelement entspricht,
b) Ausbilden einer sog. Versteifungsmanschette oder starren Umfassung (garniture de rigidité) (116) an den seitlichen Flanken (110a, 110b).
c) Entfernen des Opfermaterials von jeder Reliefstruktur (108), um die frei bewegliche Mikrostruktur, welche die Strukturschicht (104) und die Versteifungsmanschette (116) umfaßt, freizulegen.

**2.** Herstellungsverfahren einer frei beweglichen Mikrostruktur nach Anspruch 1 in einem Substrat, das ferner eine zweite Opfermaterialschicht (122) und eine zweite Strukturschicht (124) aufweist, die in dieser Reihenfolge zwischen die Trägerschicht (100) und die erste Opfermaterialschicht geschichtet sind, wobei das Ausbilden einer Reliefstruktur (108) mit seitlichen Flanken (110a, 110b) außerdem das Ätzen der zweiten Strukturschicht und mindestens eines Teils der zweiten Opfermaterialschicht (122) umfaßt, und wobei die erste Strukturschicht (104) nach dem Ausbilden der Versteifungsmanschette (116) an den seitlichen Flanken (110a, 110b) entfernt wird.

**3.** Verfahren zur Herstellung einer frei beweglichen Mikrostruktur nach Anspruch 1 in einem Substrat, das ferner eine zweite Strukturschicht (124) und eine zweite Opfermaterialschicht (122) aufweist, die in dieser Reihenfolge zwischen die Trägerschicht (100) und die erste Opfermaterialschicht (102) geschichtet sind, wobei das Verfahren ferner zwischen den Schritten a) und b) das Ätzen der zweiten Strukturschicht (124) und das Ätzen mindestens eines Teils der zweiten Opfermaterialschicht (122) gemäß dem Muster, das dem frei beweglichen Mikrostrukturelement entspricht, gefolgt von dem Entfernen der ersten Schicht (104) der Struktur, umfaßt.

**4.** Verfahren nach einem der Ansprüche 1 bis 3, **dadurch gekennzeichnet, daß** das Ätzen der Opfermaterialschicht (102) ein anisotroper Ätzvorgang ist.

**5.** Verfahren nach einem der Ansprüche 2 bis 4, **dadurch gekennzeichnet, daß** das Ätzen der zweiten Opfermaterialschicht (124) ein anisotroper Ätzvorgang ist.

**6.** Verfahren nach einem der Ansprüche 1 bis 3, **dadurch gekennzeichnet, daß** das Ätzen der Opfermaterialschicht (102) ein isotroper Ätzvorgang ist.

**7.** Verfahren nach einem der Ansprüche 2 bis 4, **dadurch gekennzeichnet, daß** das Ätzen der zweiten Opfermaterialschicht ein isotroper Ätzvorgang ist.

**8.** Verfahren nach Anspruch 1, **dadurch gekennzeichnet, daß** vor dem Schritt a) auf der Strukturschicht (104) eine das Ätzmuster festlegende Maske (106) ausgebildet wird.

**9.** Verfahren nach Anspruch 8, **dadurch gekennzeichnet, daß** die Maske (106) vor der Bildung der Versteifungsmanschette (116) entfernt wird.

**10.** Verfahren nach Anspruch 8, **dadurch gekennzeichnet, daß** die Maske (106) nach der Bildung der Versteifungsmanschette (116) entfernt wird, wobei die Maske einen Teil der Reliefstruktur (108) mit seitlichen Flanken (110a, 110b) bildet.

**11.** Verfahren nach Anspruch 1, **dadurch gekennzeichnet, daß** die Bildung der Versteifungsmanschette (116) das Aufbringen mindestens einer Materialschicht (112), welche jede Reliefstruktur (108) bedeckt, und das anisotrope Ätzen ohne Maskierung dieser Schicht (112) umfaßt.

**12.** Verfahren nach Anspruch 1, **dadurch gekennzeichnet, daß** für die Bildung der Versteifungsmanschette (116) mindestens eines von folgenden Materialien gewählt wird: Siliziumnitrid, Siliziumoxid und Silizium oder ein Metall.

**13.** Verfahren zur Herstellung von Hängeträgern eines aufgehängten Abschnitts einer mikromechanischen Vorrichtung, **dadurch gekennzeichnet, daß** die Hängeträger gemäß dem Verfahren des Anspruchs 1 gefertigt werden.

**14.** Mikromechanische Vorrichtung mit einem tragenden Substrat (100), einer "schwimmenden" bzw. frei beweglichen Struktur, die vom Substrat getrennt ist, und mindestens einem Hängeträger, der die frei bewegliche Struktur mit dem Substrat verbindet, **dadurch gekennzeichnet, daß** der Träger Seitenränder (130) aufweist, die mit Versteifungsmanschetten (116) versehen sind, welche sich entlang der Ränder des Trägers und über die Ränder hinaus in Richtungen erstrecken, die im wesentlichen senkrecht zur Achse des Trägers sind.

**15.** Vorrichtung nach Anspruch 14, **dadurch gekennzeichnet, daß** die frei bewegliche Struktur auch mit Versteifungsmanschetten versehene Seitenränder aufweist, wobei die Versteifungsmanschetten einen Rahmen bilden.

**16.** Vorrichtung nach Anspruch 14, **dadurch gekennzeichnet, daß** der Träger mindestens eine Materialschicht umfaßt, die aus den folgenden Materialien ausgewählt ist: Silizium, Siliziumoxid, Siliziumnitrid und Metall.

**17.** Vorrichtung nach Anspruch 14, **dadurch gekennzeichnet, daß** der Träger eine alternierende Schichtung aus mindestens einer Schicht aus elektrisch leitendem Material und mindestens einer Schicht aus elektrisch isolierendem Material umfaßt.

**18.** Vorrichtung nach Anspruch 17, **dadurch gekennzeichnet, daß** die Versteifungsmanschetten Abschnitte aus elektrisch isolierenden Material mindestens in den Zonen, die mit der Schicht aus elektrisch leitendem Material der Schichtung in Kontakt stehen, aufweisen.

**19.** Vorrichtung nach Anspruch 14, **dadurch gekennzeichnet, daß** die Manschetten bzw. Umfassungen aus einem Material gefertigt sind, das aus Siliziumoxid, Siliziumnitrid, Silizium und den Metallen gewählt ist.

**20.** Vorrichtung nach Anspruch 14, **dadurch gekennzeichnet, daß** die "schwimmende" bzw. frei bewegliche Struktur der sensible Teil eines Mikro-Bolometers ist.

FIG. 2

FIG.1

FIG. 3

FIG. 4A

FIG. 4B

FIG. 5A

FIG. 5B

FIG. 6A

FIG. 6B

FIG. 7A

FIG. 7B

FIG. 8

FIG. 9A

FIG. 9B

FIG. 10A

FIG. 11A

FIG. 11B

FIG. 12 A

FIG. 12 B

FIG. 13 A

FIG. 13 B

FIG. 14

FIG. 15

FIG. 16

FIG. 17

FIG. 18

FIG. 19

FIG. 20

FIG. 21

FIG. 22

FIG. 23

FIG. 24

FIG. 25

FIG. 26

FIG. 27

FIG. 28

FIG. 29

FIG. 30

FIG. 31

FIG. 32